# EUROPEAN PATENT APPLICATION

(11) **EP 4 575 528 A1**
(43) Date of publication of application: **25.06.2025**
(21) Application number: 23219183.3
(22) Date of filing: 21.12.2023
(51) Int. Cl.: G01R 31/08, G01R 31/52

(54) **METHOD FOR DETECTING A STATE OF A RETURN ELEMENT CONNECTED TO A SENSING SYSTEM OF A HIGH VOLTAGE DIRECT CURRENT POWER TRANSMISSION SYSTEM, SYSTEM, COMPUTER PROGRAM PRODUCT AND COMPUTER-READABLE STORAGE MEDIUM**

(71) Applicant: Hitachi Energy Ltd, 8050 Zürich (CH)
(72) Inventor: Bjorklund, Hans, 77142 Ludvika (SE)
(74) Representative: Epping - Hermann - Fischer

(57) **Abstract**

A method for detecting a state of a return element (1) connected to a sensing system (2) of a high voltage direct current, HVDC, power transmission system (3) is provided, comprising:
- providing an initial electromagnetic model characteristic of the return element (1) and the sensing system (2), wherein the return element (1) has no defective parts,
- providing at least one altered electromagnetic model based on the initial electromagnetic model, wherein the return element (1) has at least one defective part,
- providing a plurality of predetermined input pulses (4), which are provided to the initial electromagnetic model and the altered electromagnetic model, wherein some of the predetermined input pulses (4) are different from one another,
- providing a trained model of the return element (1) and the sensing system (2), wherein the trained model is generated dependent on a plurality of responses to the provision of the plurality of predetermined input pulses (4),
- detecting the state of the return element (1) dependent on some of the predetermined input pulses (4) applied to the return element (1) and dependent on the trained model.

Additionally, a system (14), a computer program product and a computer-readable storage medium are provided.

## Description

The present disclosure relates to a method for detecting a state of a return element connected to a sensing system of a high voltage direct current, HVDC, power transmission system, a system, a computer program product and a computer-readable storage medium.

For typical return elements as electrode lines and dedicated metallic return elements of HVDC power transmission systems such as bidirectional high voltage direct current, HVDC, power transmission systems, fault detection is difficult as in normal operation there is no voltage and no current flowing in the return elements.

Embodiments of the disclosure relate to a method by means of which a determination of a health state of the return element is improved. A further embodiment relates to a system configured to perform such a method, as well as a computer program product and a computer readable storage medium.

This is achieved by the subject-matter of the independent claims. Further embodiments are evident from the dependent claims and the following description.

A method for detecting a state of a return element connected to a sensing system of an HVDC power transmission system is described. The HVDC power transmission system is exemplarily configured to transmit a bulk power over a comparatively long distance from point to point. In particular, the HVDC power transmission system is a monopolar or bipolar HVDC power transmission system. The HVDC power transmission system is connected in particular to the return element.

The return element is, for example, an electrode line, a dedicated metallic return element, a dedicated metallic return cable and/or combinations thereof. In particular, the return element is configured to provide an electrically conductive path through which a direct current of the HVDC power transmission system completes its circuit after flowing from the one point to the other point.

The sensing system is configured to provide measurement information of the return element. The measurement information can comprise voltage information and/or current information. Exemplarily, the return element and the sensing system each comprise a plurality of electrical components.

According to an embodiment of the method, an initial electromagnetic model characteristic of the return element and the sensing system is provided, wherein the return element has no defective parts. The initial electromagnetic model is exemplarily a mathematical model being characteristic of at least some or all of the electrical components of the return element and the sensing system. The initial electromagnetic model in particular considers at least one of the following factors: voltage fluctuations, current fluctuations, electromagnetic interference, a dynamic behavior of the electrical components such as transmission lines, transmission cables, sensor devices and/or further electrical devices.

The initial electromagnetic model is exemplarily used for performing an electromagnetic transient, EMT, simulation. The transients refer to short-duration events such as switching operations, faults, and/or sudden changes in the electrical network of the electrical components.

Further, the sensing system can have no defective parts. Having no defective parts means here and in the following that the return element or the return system and the sensing system are healthy, e.g. are in a good operating condition and performing as required within predetermined parameters. Exemplarily, this means that the corresponding electrical components are healthy and in particular operate reliably, efficiently and/or safely, without any noticeable faults, defects and/or abnormalities.

According to the embodiment, at least one altered electromagnetic model is provided, which is based on the initial electromagnetic model, wherein the return element has at least one defective part. Exemplarily, the initial electromagnetic model is altered by exchanging at least one of the healthy electrical components with at least one electrical component having a defective part.

Further, the sensing system can have at least one defective part. Having a defective part means here and in the following that the return element or the return element and the sensing system are not in a good operating condition and do not perform as required. Exemplarily, this means that the corresponding electrical components are defective and in particular do not operate reliably, efficiently and/or safely. In particular, the defective electrical components have noticeable faults, defects and/or abnormalities.

For example, a plurality of altered electromagnetic models are provided, all being based on the initial electromagnetic model. At least some or all of the plurality of altered electromagnetic models are exemplarily different from one another with respect to their defective part or defective parts. In particular, the plurality of altered electromagnetic models are characteristic of the return element comprising at least some or all conceivable defectives, such as e.g. fault conditions and/or fault locations being represented by the defective parts.

According to the embodiment, a plurality of predetermined input pulses are provided, which are provided to the initial electromagnetic model and the altered electromagnetic model, wherein some of the predetermined input pulses are different from one another. Exemplarily, the predetermined input pulses are virtually applied to the return elements of the initial electromagnetic model and the altered electromagnetic model. This means that in this method stage, the predetermined input pulses are virtual predetermined input pulses. For example, the plurality of predetermined input pulses form a predetermined input signal, which in this method stage is a virtual predetermined input signal.

Exemplarily, one or a plurality of predetermined input signals is/are provided to the initial electromagnetic model and the altered electromagnetic model, wherein the predetermined input signals, in particular all of them, are different from one another.

Exemplarily, each input pulse is represented by parameters such as frequency, amplitude, shape and/or number of periods, wherein at least one of the parameters is different for some of the predetermined input pulses. In particular, all of the predetermined input pulses are different from one another. This means in particular that the predetermined input signal comprises pulses having different parameters.

When the predetermined input pulses, i.e. the predetermined input signal, is/are provided to the initial electromagnetic model and the altered electromagnetic model, particularly to each of the altered electromagnetic models, a response can be simulated for each case. The responses are in particular virtual responses. The responses are in particular simulated using the EMT simulation. In particular, a behavior of the return element and the sensing system can be simulated as the response to the provision of the predetermined input pulses, i.e. the predetermined input signal. In particular, the responses are characteristic of a time series of simulated data of the sensing system. The respective time series starts, for example, directly subsequent to the provision of the predetermined input pulses. The time series particularly have a length corresponding to a predetermined time interval. The predetermined time interval is, for example, at most 0.3 s, at most 0.1 s or at most 0.05 s or at most 0.01 s.

Exemplarily, the predetermined input pulses are each characteristic of a current pulse. For example, the generation of the response is performed automatically.

According to the embodiment, a trained model of the return element and the sensing system is provided, wherein the trained model is generated dependent on a plurality of responses to the provision of the plurality of predetermined input pulses. Exemplarily, the responses, in particular the simulated responses, are used as an input for a machine learning algorithm for generating the trained model.

After the trained model is generated, the trained model can be compiled and, for example, transferred in an analyzing computing device connected to the sensing system. It is also conceivable that the trained model can be generated and compiled on the analyzing computing device.

According to the embodiment, the state of the return element is detected dependent on some of the predetermined input pulses applied to the return element and dependent on the trained model. Exemplarily, the predetermined input pulses are physically applied to the return element of the HVDC transmission system. This means that in this method stage, the predetermined input pulses are physical predetermined input pulses. For example, in this method stage the physical predetermined input pulses form the predetermined input signal, particularly a physical predetermined input signal. Exemplarily, the physical predetermined input pulses are characteristic of the virtual predetermined input pulses. In particular, the physical predetermined input signal is characteristic of the virtual predetermined input signal.

The predetermined input signal is applied, for example, regularly to the return element, measuring a response for each case. A time interval for applying the predetermined input signal to the return element is, for example, at least 0.01 s and/or at most 1 day, at most 1 hour, at most 1 minute or at most 1 s.

When applying the predetermined input pulses, in particular the predetermined input signal, to the return element, the sensing system is configured to measure a response. In particular, each of the measured responses is characteristic of a time series of measured data of the sensing system.

Exemplarily, the method is a computer implemented method. In particular, the method stages are carried out in the order indicated.

Advantageously, by using the trained model and the measured response, the state of the return element can be determined, as the trained model comprises all response situations comprising all conceivable defective parts.

According to a further embodiment, some of the predetermined input pulses have a different frequency from one another, some consecutive predetermined input pulses are characteristic of a frequency sweep and/or some of the predetermined input pulses have a different pulse shape from one another. Exemplarily, each input pulse is characterized by one period of a predetermined frequency and a predetermined amplitude.

Exemplarily, the predetermined input pulses are grouped into blocks. Each block comprises at least some of the predetermined input pulses of the same frequency. In particular, the frequency of consecutive predetermined input pulses does not change over time within the same block. For example, the frequencies of the blocks are different from one another. This means that the predetermined input signal exemplarily comprises several blocks, wherein the frequencies of the blocks are different from one another.

Alternatively, the frequencies of at least some consecutive predetermined input pulses change over time within the same block.

When some consecutive predetermined input pulses are characteristic of the frequency sweep, the frequency of at least some consecutive predetermined input pulses changes over time. In particular, the frequency of the consecutive predetermined input pulses increases or decreases gradually, generating the frequency sweep across different frequencies.

The pulse shape is, in particular, characteristic of the frequency, i.e. a duration, the amplitude, a rise time and a fall time.

The predetermined input pulses, in particular the input signal, is/are advantageously fully programmable such that any type of signal can be constructed. By using different frequencies, advantageously, blind zones and disturbances from other lines can be particularly avoided.

According to a further embodiment, some of the predetermined input pulses are characteristic of white noise. Exemplarily, the predetermined input pulses characteristic of white noise correspond to a random signal that encompasses a plurality of frequencies, in particular in equal proportions.

Advantageously, an injection of the white noise signal exemplarily in combination with an analysis of an impedance, measured through the sensing system, over a wide range is an effective method when the configuration of the return element is uncertain or varies.

According to a further embodiment, detecting the state of the return element dependent on the trained model comprises detecting that the state of the return element is healthy. Exemplarily, if a comparison of the trained model with the measured response is indicative of that there are no defective parts in the return element, the return element is considered healthy.

According to a further embodiment, detecting the state of the return element dependent on the trained model comprises detecting that the state of the return element is defective. Exemplarily, if a comparison of the trained model with the measured response is indicative of that there is at least one defective part in the return element, the return element is considered defective.

According to a further embodiment, a location of the defective part of the return element is provided. Exemplarily, as a result of the comparison the at least one defective part is determined, e.g. outputted, wherein the defective part comprises the location within the return element. Exemplarily, the result comprises a detection of a fault, a classification of the fault, and a location of the fault.

Thus, advantageously, not only a fault detection is implemented with such a method, but also the precise localization of the fault is determined. This advantageously improves troubleshooting of defective return elements.

According to a further embodiment, the trained model is generated by a machine learning process. Exemplarily, the trained model is generated by the use of a machine learning algorithm. For example, the trained model is generated by a training process where the trained model learns from data, i.e. the initial and altered electromagnetic model in combination with the virtual responses. In particular, the trained model is used to recognize patterns and/or make predictions based on input data, such as the measured response.

Using the machine learning process, the trained model can be generated automatically, for example. Thus, the processes are advantageously efficient and less reliant on manual intervention.

Additionally, using the machine learning process advantageously enables a handling of particularly large and complex datasets and deriving patterns. Such a generated trained model can advantageously adapt to new data, allowing the trained model to be improved as more information becomes available.

According to a further embodiment, the trained model is updated dynamically dependent on measurement data of the return element. Typically, the return element is healthy, and the measured responses are characteristic of a healthy return element. Exemplarily, the trained model can be further trained dependent on the measured responses, where the return element is healthy. Thus, the initial electromagnetic model is advantageously improved using real data of the real return element.

Additionally or alternatively, for example, the trained model is adaptive dependent on historical data. The historical data are in particular characteristic of a plurality of measured responses acquired.

According to a further embodiment, the sensing system comprises an output unit configured to provide the predetermined input pulses to the return element. In particular, the output unit is configured to apply the physical predetermined input pulses, e.g. the physical predetermined input signal, to the return element.

According to a further embodiment, the sensing system comprises an input unit configured to measure electrical properties of the return element. In particular, the sensing system is configured to measure the response upon applying the predetermined input pulses to the return element.

Exemplarily, the sensing system is additionally configured to measure mechanical properties of the return element. For example, the sensing system comprises at least one mechanical sensor and/or at least one sound detection sensor.

According to a further embodiment, the input unit comprises a voltage sensor device configured to measure a voltage of the return element.

According to a further embodiment, the input unit comprises a first current sensor device configured to measure a current of the return element.

According to a further embodiment, the input unit comprises a second current sensor device configured to measure a current of the output unit.

In particular, the sensor system and the output unit are connected to the analyzing computing device. Exemplarily, the measurement information comprises information of the voltage sensor device, the first current sensor device and the second current sensor device characteristic of the response. For example, the measurement information is simultaneously sampled and logged by the analyzing computing device.

According to a further embodiment, the output unit comprises an amplifier and a coupling capacitor.

According to a further embodiment, the coupling capacitor is connected to the return element.

According to a further embodiment, the output unit comprises at least one converter of the transmission system. The at least one converter is, for example, part of the HVDC power transmission system. The converter is at least one of a Voltage Source Converter, VSC, and a Line Commutated Converter, LCC.

A further embodiment relates to a system, in particular configured to perform the method described herein above. Therefore, the features as described in connection with the system are also applicable to the method and vice versa.

According to the embodiment, the system comprises a return element. The return element is the return element, in particular the physical return element, described herein above.

According to the embodiment, the system comprises a sensing system. The sensing system is the sensing system, in particular the physical sensing system, described herein above.

According to the embodiment, the system comprises an analyzing computing device which is configured to perform the method described herein above. The analyzing computing device is in direct contact with the sensing system, for example. This means that the analyzing computing device is in particular in contact with the return element via the sensing system.

A further embodiment relates to a computer program product comprising instructions which, when the computer program is executed by a processor, cause the computer program to execute the method described herein above. In particular, the computer program product can be implemented as hardware control, software control and/or firmware control or combinations thereof.

Exemplarily, the computer program product is a volatile data file which has to be introduced into the system described herein above via a data interface.

A further embodiment relates to a computer-readable storage medium on which the computer program product described herein above is stored.

The accompanying Figures are included to provide a further understanding. In the Figures, elements of the same structure and/or functionality may be referenced by the same reference signs. It is to be understood that the embodiments shown in the Figures are illustrative representations and are not necessarily drawn to scale.
Figures 1 and 2 each schematically shows a system according to an exemplary embodiment.
Figure 3 schematically shows a flow diagram of a method for generating a trained model which is provided for a method according to an exemplary embodiment.
Figure 4 schematically shows a flow diagram of a method according to an exemplary embodiment.
Figures 5, 6, 7 and 8 each schematically show different predetermined input pulses 4 used in the method according to an exemplary embodiment.

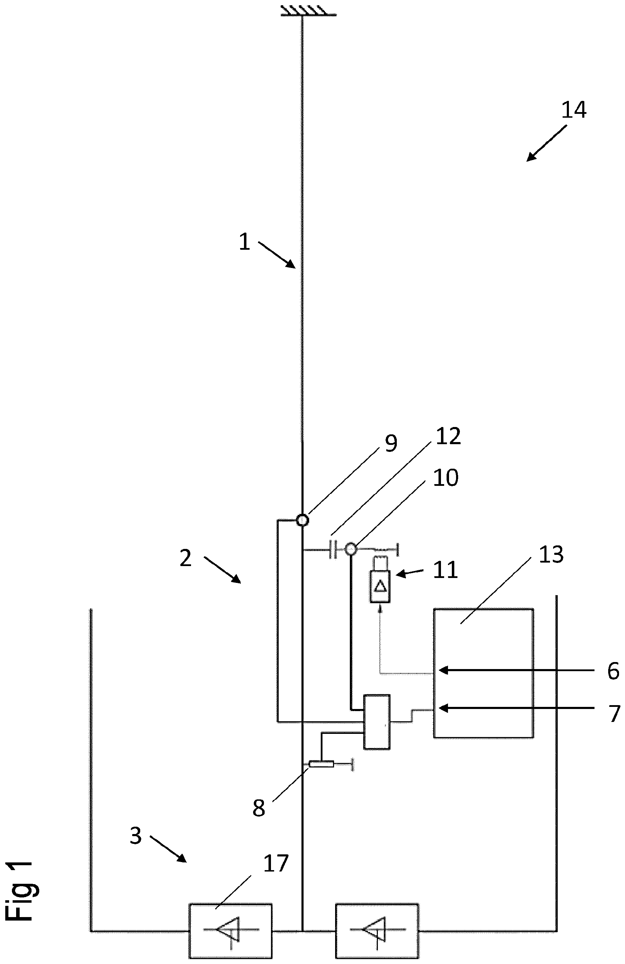

The system 14 according to the exemplary embodiment of Figure 1 comprises a sensing system 2 and a return element 1 configured to be connected to an HVDC power transmission system. In particular, the return element 1 is connected to the HVDC power transmission system. The sensing system 2 is connected to the return element 1. The sensing system 2 is further connected to an analyzing computing device 13. The analyzing computing device 13 is connected to the return element 1 via the sensing system 2.

In particular, the return element 1 is arranged between the HVDC power transmission system 3 and a reference potential, e.g. a ground potential.

The HVDC power transmission system 3 particularly comprises a converter 17.

The sensing system 2 comprises an output unit 6 configured to provide predetermined input pulses 4, in particular physical predetermined input pulses 4, to the return element 1. The output unit 6 comprises an amplifier 11 and a coupling capacitor 12, wherein the coupling capacitor 12 is connected to the return element 1. In particular, a signal corresponding to the predetermined input pulses 4 is provided by the analyzing computing device 13 to the amplifier, where the signal corresponding to the predetermined input pulses 4 is amplified. The amplified signal corresponding to the predetermined input pulses 4 is applied to the return element 1 via the coupling capacitor 12.

The sensing system 2 comprises an input unit 7 configured to measure electrical properties of the return element 1. The input unit 7 comprises a voltage sensor device 8 configured to measure a voltage of the return element 1, a first current sensor device 9 configured to measure a current of the return element 1, and a second current sensor device 10 configured to measure a current of the output unit 6.

The voltage sensor device 8 is in particular arranged between a node of the return element 1 connected to the coupling capacitor and a node of the return element 1 connected to the HVDC power transmission system 3. The first current sensor device 9 is in particular arranged between the node of the return element 1 connected to the coupling capacitor and a node of the return element 1 connected to the reference potential. The second current sensor is arranged between the coupling capacitor and the amplifier, in particular on a side of the coupling capacitor.

The voltage sensor device 8 is in particular arranged directly on the return element 1. The first current sensor device 9 is in particular arranged directly on the return element 1.

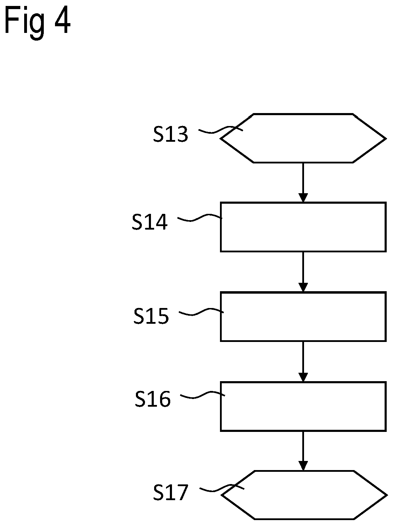

The analyzing computing device 13 is configured to receive measurement signals from the input unit 7 and is configured to provide the signal corresponding to the predetermined input pulses 4 to the output unit 6. The analyzing computing device 13 is configured to perform the method described in connection with Figure 4.

In particular, the return element 1 of the system 14 of Figure 1 is characteristic for an electrode line and the system 14 with the sensing system 2 is configured for a supervision of the electrode line.

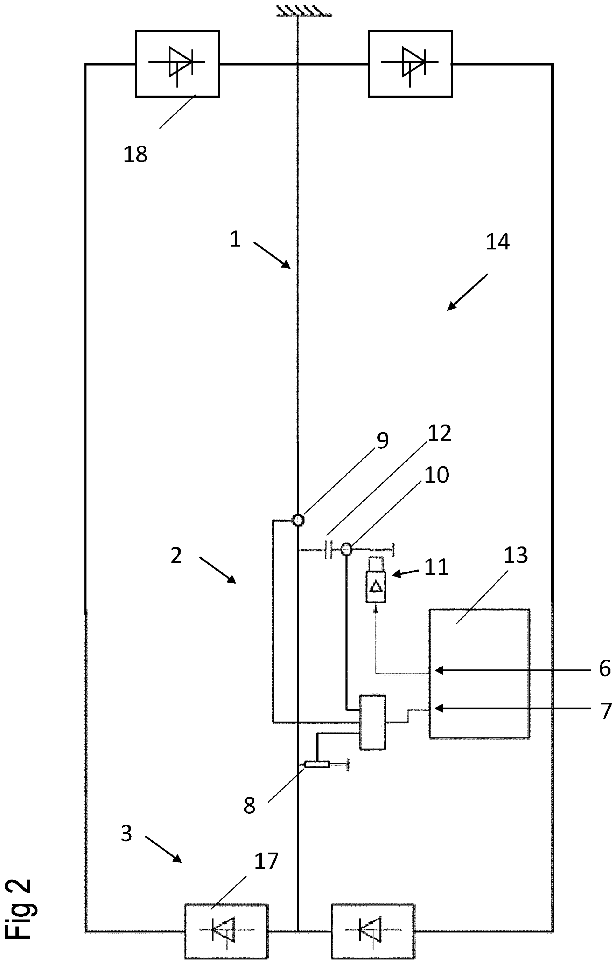

The system 14 according to the exemplary embodiment of Figure 2 additionally comprises with respect to the system 14 of Figure 1, a further converter 18. In particular, the return element 1 of the system 14 of Figure 2 is characteristic for a dedicated metallic return, DMR, line arranged between the converter 17 and the further converter 18. In particular, the system 14, i.e. the HDVC power transmission system 3 has a bipolar configuration.

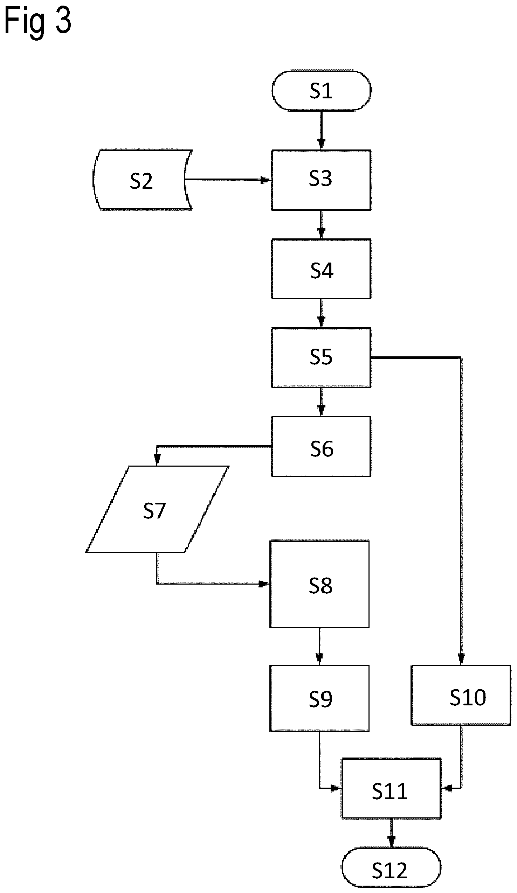

Method stages S1 to S12 according to the exemplary embodiment of Figure 3 describe how a trained model is generated and deployed in the analyzing computing device 13 shown in Figure 1. The process according to Figure 3 comprises pre-performed method stages, being performed before the method described in connection with Figure 4 is carried out. The method according to Figure 3 is carried out, for example, on the analyzing computing device 13 or an external computing device.

Method stage S1 is indicative of a start. In method stage S2 data characteristic of the return element 1, the sensing system 2 and in particular the HVDC power transmission system 3 are provided. The data are characteristic of an arrangement and properties of the electrical components of the return element 1, the sensing system 2 and in particular the HVDC power transmission system 3. In this method stage, all the electrical components are considered as healthy.

In method stage S3 an initial electromagnetic model is generated based on the data provided in method stage S2. In method stage S4, at least one altered electromagnetic model is generated based on the initial electromagnetic model. For generating the altered electromagnetic model, a part of the initial electromagnetic model corresponding to a healthy electrical component is altered to a defective electrical component. Therefore, each altered electromagnetic model is characteristic of at least one or more defective parts. Different altered electromagnetic models are characteristic of at least one different defective part.

In method stage S5, a plurality of predetermined input pulses 4 is generated, wherein at least some or all of the predetermined input pulses 4 are different from one another, particularly forming a predetermined input signal. In method stage S6, the predetermined input pulses 4 generated in method stage S5 are provided to each of the initial electromagnetic model and the altered electromagnetic models.

In method stage S7, the predetermined input pulses 4, i.e. the predetermined input signal, is/are provided to the initial electromagnetic model and the altered electromagnetic models, particularly to each of the altered electromagnetic models, wherein a response is simulated for each case. The response is characteristic of electronic properties of the sensing system 2. In particular, each response is characteristic of a voltage information of the voltage sensor device 8, a first current information of the first current sensor device 9, and a second current information of the second current sensor device 10. The voltage information, the first current information and the second current information are each in particular represented by a time series of the respective simulated data. Each response can further comprise a classification if the response corresponds to a defective or healthy return element 1 and/or a location of the defective part.

A trained model of the return element 1 and the sensing system 2 is generated in method stage S8, wherein the trained model is generated dependent on the plurality of responses to the provision of the plurality of predetermined input pulses 4.

In method stage S9 the trained model is provided to the analyzing computing device 13. In method stage S10, the predetermined input pulses 4, particularly the predetermined input signal, is/are provided to the analyzing computing device 13.

In step S11, the process for generating the trained model and deploying the trained model to the analyzing computing device 13 is terminated.

In method stage S13 according to Figure 4, an initial electromagnetic model characteristic of the return element 1 and the sensing system 2 is provided, wherein the return element 1 has no defective parts, as described analogously in connection with method stage S3.

Subsequently, in method stage S14 at least one altered electromagnetic model is provided based on the initial electromagnetic model, wherein the return element 1 has at least one defective part, as described analogously in connection with method stage S4.

Next, in method stage S15 a plurality of predetermined input pulses 4 are provided, which are provided to the initial electromagnetic model and the altered electromagnetic model, wherein some of the predetermined input pulses 4 are different from one another, as described analogously in connection with method stage S5 and S6.

In method stage S16, a trained model of the return element 1 and the sensing system 2 is provided, wherein the trained model is generated dependent on a plurality of responses to the provision of the plurality of predetermined input pulses 4, as described analogously in connection with method stages S7 and S8.

In method stage S17 the state of the return element 1 is detected dependent on some of the predetermined input pulses 4 applied to the return element 1 and dependent on the trained model. For this, the predetermined input pulses 4 are applied to the return element 1 via the output unit 6 described in Figure 1. A response is measured via the input unit 7 described in Figure 1 upon applying the predetermined input pulses 4. The response is provided to the trained model, wherein the state is detected to be healthy or defective.

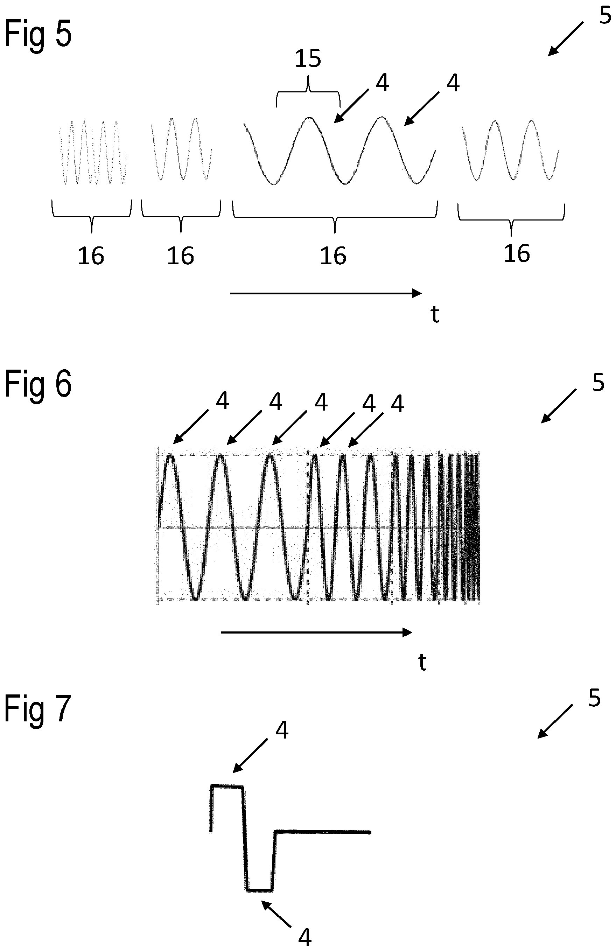

At least some of the predetermined input pulses 4 according to Figure 5 have a different frequency from one another. Each predetermined input pulse 4 is characterized by one period 15 of a predetermined frequency and a predetermined amplitude. The predetermined input pulses 4 are grouped into blocks 16. Each block 16 comprises at least some of the predetermined input pulses 4 of the same frequency, such that each block 16 corresponds to one frequency. The frequencies of different blocks 16 are different from one another. This means that the predetermined input signal comprises the blocks 16, wherein the frequencies of the blocks 16 are different from one another.

According to Figure 6, consecutive predetermined input pulses 4 are characteristic of the frequency sweep, wherein the frequency of at least some consecutive predetermined input pulses 4 changes over time. The frequency of the consecutive predetermined input pulses 4 increases gradually.

The predetermined input pulses 4 according to Figure 7 have a different shape from one another. In particular, the shapes can be adapted dependent on the arrangement of the electronic components.

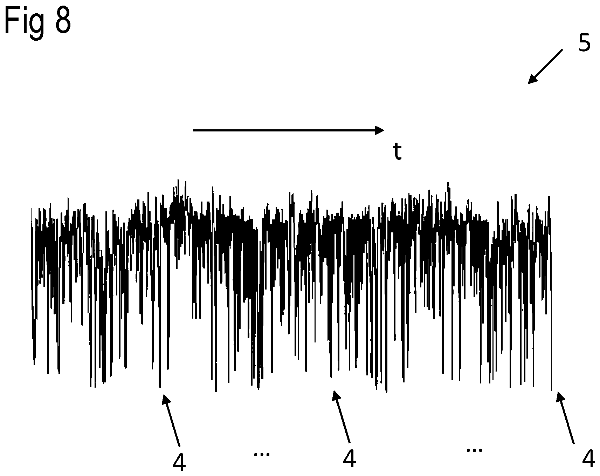

The predetermined input pulses 4 according to Figure 8, in particular the predetermined input signal, is/are characteristic of white noise.

The embodiments and exemplary embodiments described herein above can be combined accordingly.

### Reference Signs

- 1: return element
- 2: sensing system
- 3: HVDC power transmission system
- 4: predetermined input pulses
- 5: predetermined input signal
- 6: output unit
- 7: input unit
- 8: voltage sensor device
- 9: first current sensor device
- 10: second current sensor device
- 11: amplifier
- 12: coupling capacitor
- 13: analyzing computing device
- 14: system
- 15: period
- 16: block
- 17: converter
- 18: further converter

- S1..S17: method stages

## Claims

1. Method for detecting a state of a return element (1) connected to a sensing system (2) of a high voltage direct current, HVDC, power transmission system (3), comprising:
- providing an initial electromagnetic model characteristic of the return element (1) and the sensing system (2), wherein the return element (1) has no defective parts,
- providing at least one altered electromagnetic model based on the initial electromagnetic model, wherein the return element (1) has at least one defective part,
- providing a plurality of predetermined input pulses (4), which are provided to the initial electromagnetic model and the altered electromagnetic model, wherein some of the predetermined input pulses (4) are different from one another,
- providing a trained model of the return element (1) and the sensing system (2), wherein the trained model is generated dependent on a plurality of responses to the provision of the plurality of predetermined input pulses (4),
- detecting the state of the return element (1) dependent on some of the predetermined input pulses (4) applied to the return element (1) and dependent on the trained model.

2. Method according to claim 1, wherein
- some of the predetermined input pulses (4) have a different frequency from one another, some consecutive predetermined input pulses (4) are characteristic of a frequency sweep and/or some of the predetermined input pulses (4) have a different pulse shape from one another, and/or
- some of the predetermined input pulses (4) are characteristic of white noise.

3. Method according to one of claims 1 or 2, wherein detecting the state of the return element (1) dependent on the trained model comprises:
- detecting that the state of the return element (1) is healthy.

4. Method according to one of claims 1 to 3, wherein detecting the state of the return element (1) dependent on the trained model comprises:
- detecting that the state of the return element (1) is defective.

5. Method according to claim 4, wherein
- a location of the defective part of the return element (1) is provided.

6. Method according to one of claims 1 to 5, wherein
- the trained model is generated by a machine learning process.

7. Method according to one of claims 1 to 6, wherein
- the trained model is updated dynamically dependent on measurement data of the return element (1).

8. Method according to one of claims 1 to 7, wherein
- the sensing system (2) comprises an output unit (6) configured to provide the predetermined input pulses (4) to the return element (1), and
- the sensing system (2) comprises an input unit (7) configured to measure electrical properties of the return element (1).

9. Method according to claim 8, wherein
- the input unit (7) comprises a voltage sensor device (8) configured to measure a voltage of the return element (1),
- the input unit (7) comprises a first current sensor device (9) configured to measure a current of the return element (1), and
- the input unit (7) comprises a second current sensor device (10) configured to measure a current of the output unit (6).

10. Method according to one of claims 8 or 9, wherein
- the output unit (6) comprises an amplifier (11) and a coupling capacitor (12), and
- the coupling capacitor (12) is connected to the return element (1).

11. Method according to one of claims 8 or 9, wherein
- the output unit (6) comprises at least one converter of the transmission system.

12. System (14) comprising
- a return element (1),
- a sensing system (2) connected to the return element (1), and
- an analyzing computing device (13) which is configured to perform the method according to one of claims 1 to 11.

13. Computer program product comprising instructions which, when the computer program is executed by a processor, cause the computer program to execute the method according to one of claims 1 to 11.

14. Computer-readable storage medium on which the computer program product according to claim 13 is stored.
